# EUROPÄISCHE PATENTANMELDUNG

(11) **EP 4 730 392 A2**
(43) Veröffentlichungstag der Anmeldung: **22.04.2026**
(21) Anmeldenummer: 25208811.7
(22) Anmeldetag: 15.10.2025
(51) Int. Cl.: H01J 37/32

(54) **WERKSTÜCKHALTERUNG, HALTE- UND DICHTVORRICHTUNG SOWIE PLASMABEHANDLUNGSANLAGE**

(30) Priorität: 18.10.2024 DE 102024130350
(71) Anmelder: KHS GmbH, 44143 Dortmund (DE)
(72) Erfinder: Andersen, Patrick, 44143 Dortmund (DE); Brzezinski, Milosz, 44143 Dortmund (DE); Demirel, Ali Orhan, 44143 Dortmund (DE); Kos, Simon, 44143 Dortmund (DE); Roling, Matthias, 44143 Dortmund (DE); Schetle, Andreas, 44143 Dortmund (DE); Schmidt, Dieter, 44143 Dortmund (DE)
(74) Vertreter: Andrejewski - Honke Patent- und Rechtsanwälte Partnerschaft mbB

(57) **Zusammenfassung**

Die Erfindung betrifft eine Werkstückhalterung (10), insbesondere für eine Halte- und Dichtvorrichtung (5) einer Plasmabehandlungsanlage (1), mit einem eine Werkstückaufnahme (11a) ausbildenden Träger (11) und mit einem Halteelement (12, 12', 12"), welches über ein Gleitlager beweglich an dem Träger (11) geführt ist. Dabei weist das Gleitlager eine erste Lagerfläche (17a, 17a') auf, an der eine zweite Lagerfläche (12a') flächig anliegt. Erfindungsgemäß sind die erste Lagerfläche (17a, 17a') und/oder die zweite Lagerfläche (12a') unterbrochen ausgebildet.

## Beschreibung

Die Erfindung betrifft eine Werkstückhalterung, insbesondere für eine Halte- und Dichtvorrichtung einer Plasmabeschichtungsanlage mit einem eine Werkstückaufnahme ausbildenden Träger und mit zumindest einem über ein Gleitlager beweglich an dem Träger geführtes Halteelement. Dabei weist das Gleitlager eine erste Lagerfläche auf, an der eine zweite Lagerfläche flächig anliegt. Die Erfindung betrifft auch eine damit ausgestattete Halte- und Dichtvorrichtung sowie eine Werkstückbehandlungsanlage, insbesondere Plasmabehandlungsanlage.

Die Werkstückhalterung ist dazu vorgesehen, ein Werkstück, insbesondere einen Behälter während eines Behandlungsprozesses zu halten, sodass dieses in einer definierten Lage und Positionierung behandelt werden kann. Insbesondere ist das Werkstück ein Behälter, sodass die Werkstückhalterung auch als Behälterhalterung bezeichnet werden kann.

Der Behälter ist insbesondere mit einer Mündung ausgestattet, wobei eine Behälterhalterung üblicherweise im Bereich dieser Mündung angreift. Dadurch kann die Mündung - und damit der Übergang zwischen dem von dem Behälter umschlossenen Innenraum sowie einem darum liegenden Außenraum kontrolliert werden.

Die gattungsgemäße Werkstückhalterung weist einen Träger auf, welcher eine insbesondere starre Werkstückaufnahme ausbildet. Die Werkstückaufnahme ist dazu eingerichtet, einen Teil des Werkstücks - bei einem Behälter insbesondere im Bereich der Mündung, z. B. in einem Halsabschnitt - formschlüssig zu umschließen. Dieser Formschluss ist dabei nur unvollständig ausgebildet, sodass das Werkstück in die Werkstückaufnahme für sich genommen eingesetzt und daraus entnommen werden kann. Eine Werkstückaufnahme für einen Behälter wird auch als Behälteraufnahme bezeichnet.

Die vorgesehene Haltefunktion entsteht im Zusammenwirken mit einem zusätzlichen Halteelement, welches gelegentlich auch als Haltefinger bezeichnet wird. Das Halteelement ist derart ausgestaltet und an dem Träger angeordnet, dass es zwischen einer geschlossenen Position, in der ein Herausfallen des Werkstücks aus der Werkstückaufnahme verhindert wird, und einer geöffneten Position, in der ein Einsetzen und Entnehmen des Werkstücks möglich ist, bewegt werden kann. Insbesondere umgreift das Halteelement dabei Das Werkstück an der Werkstückaufnahme derart, dass der Formschluss allseitig vervollständigt wird und eine Entnahme des Werkstücks (ohne Bewegung zumindest eines Halteelements) nicht möglich ist. Die Beweglichkeit des Halteelements zwischen der geschlossenen Position und der geöffneten Position wird durch das Gleitlager geführt.

Dafür, dass die erste Lagerfläche und die zweite Lagerfläche aneinander anliegen erstrecken sich diese in einer gemeinsamen Kontaktfläche. Die geometrische Ausgestaltung dieser Kontaktfläche ist durch die Art des Gleitlagers bestimmt und weist eine entsprechende Symmetrie auf. Beispielsweise kann die Kontaktfläche bei einer translatorischen Beweglichkeit eben (d. h. als Kontaktebene), bei einer Drehbeweglichkeit als Zylinderfläche oder aber auch als Kugeloberfläche ausgebildet sein. Die beiden Lagerflächen erstrecken sich in der gemeinsamen Kontaktfläche und können in diesem Umfang auch aneinander anliegen und das Gleitlager ausbilden. Die Bereiche, an denen die erste Lagerfläche und die zweite Lagerfläche innerhalb der Kontaktfläche flächig aneinander anliegen, werden auch als Lagerspalt bezeichnet. Die Lagerflächen sind jeweils als diejenigen Teile der Oberfläche zu verstehen, welche bei der Vorgesehenen Bewegung des Halteelements miteinander in Kontakt kommen.

Bei der Auslegung einer Werkstückhalterung hat die Verwendung eines Gleitlagers den Vorteil eines geringen Konstruktions- und Materialaufwands. Ebenso existieren insbesondere bei aufwendigen Behandlungsprozessen Einschränkungen hinsichtlich des zu verwendenden Materials, sodass aufwendige Konstruktionen wie gekapselte Wälzlager nicht in Betracht kommen. Eine gattungsgemäße Werkstückhalterung ist beispielsweise aus DE 10 2022 119 835 A1 bekannt.

Nachteilig hierbei ist jedoch, dass Gleitlager aufgrund ihrer einfachen Bauweise eine relativ hohe Anfälligkeit gegenüber Verschmutzungen haben. So können diese durch Rückstände und Stäube - etwa bei Beschichtungsprozessen - zusetzen und schwergängig werden. Infolgedessen kann die Beweglichkeit eingeschränkt und das ordnungsgemäße Funktionieren behindert werden. Insbesondere kann ein schwergängiges Lager dazu führen, dass beim Einsetzen eines Werkstücks in die Werkstückhalterung die Rückstellbewegung des Halteelements in die geschlossene Position nicht oder nicht schnell genug geschieht, sodass das Werkstück unkontrolliert verloren geht.

Vor diesem Hintergrund liegt der Erfindung die Aufgabe zugrunde, die Funktionsfähigkeit und Standzeit einer Werkstückhalterung insbesondere unter widrigen Umgebungsbedingungen zu verbessern. Gegenstand der Erfindung und Lösung dieser Aufgabe sind eine Wekstückhalterung gemäß Anspruch 1 und Anspruch 9, eine Halte- und Dichtvorrichtung nach Anspruch 14 sowie eine Plasmabehandlungsanlage nach Anspruch 15. Bevorzugte Ausgestaltungen sind in den abhängigen Unteransprüchen angegeben.

Ausgehend von der gattungsgemäßen Werkstückhalterung ist gemäß einem ersten Aspekt der Erfindung vorgesehen, dass die erste Lagerfläche und/oder die zweite Lagerfläche unterbrochen ausgebildet sind. Unterbrochen meint im Kontext dieser Erfindung, dass zumindest die Lagerfläche mehrere innerhalb einer gemeinsamen Kontaktfläche verlaufende Segmente aufweist, welche durch zumindest eine außerhalb der Kontaktfläche liegende und sich insbesondere von der Lagerfläche des gegenüberliegenden Lagerpartners weg erstreckende Unterbrechung getrennt sind. Während die Segmente der Lagerfläche mit der gegenüberliegenden Lagerfläche in Kontakt treten können, ist ein solcher Kontakt im Bereich der Unterbrechung geometrisch ausgeschlossen. Dadurch wird zwar die Fläche, mit der die erste Lagerfläche und die zweite Lagerfläche in Kontakt treten, reduziert. Gemäß der Erfindung führen die dazwischenliegenden Unterbrechungen zu einem zuverlässigen Abtransport von Verunreinigungen, welche in den Lagerspalt zwischen den beiden Lagerflächen geraten sind. Dadurch kann ein Zusetzen des Gleitlagers verhindert werden. Auch reduzieren sich durch einen flächenmäßig kleineren Lagerspalt mit Kontakt zwischen der ersten Lagerfläche und der zweiten Lagerfläche Kapillarräume, in die Fremdstoffe gelangen können. Die kann beispielsweise durch häufige Druckwechsel geschehen - etwa beim wiederholten Evakuieren einer Plasmabehandlungsstation und anschließenden Angleichen an den Umgebungsdruck.

Gemäß einer bevorzugten Ausgestaltung weist das Gleitlager einen Lagerbolzen mit einer um eine Drehachse rotationssymmetrisch ausgebildeten

Außenfläche auf, welcher die erste Lagerfläche bildet. Weiterhin sind das Halteelement und/oder der Träger mit einer um die Drehachse rotationssymmetrisch angeordneten Innenfläche ausgebildet, welche die zweite Lagerfläche bildet und an der Außenfläche anliegt. Diese Ausgestaltung ermöglicht die Ausbildung eines rotativen Gleitlagers, welches eine Schwenkbewegung des Halteelements um die Drehachse ermöglicht. **In** Verbindung mit den erfindungsgemäßen Unterbrechungen einer oder beider Lagerflächen sind diese gegenüber einer Verschmutzung besser geschützt.

Gemäß einer ersten bevorzugten Ausgestaltung weist der Lagerbolzen eine umlaufend zylindrische Außenform auf, welche durch längs zu der Drehachse, insbesondere parallel dazu, verlaufende Vertiefungen unterbrochen ist. Die Ausbildung der Vertiefungen an dem Lagerbolzen ermöglicht es, diesen in besonders einfacher Weise gegen einen konventionellen Lagerbolzen auszutauschen. Dabei bleibt die Funktionsfähigkeit mit einem üblichen Halteelement oder Träger - welche umlaufend zylindersymmetrisch innere Lagerflächen aufweisen - problemlos möglich. Vorzugsweise weisen die Vertiefungen eine längs der Drehachse konstante Querschnittsform auf.

Alternativ oder zusätzlich kann vorgesehen sein, dass die Innenfläche zylindersymmetrisch mit zumindest einer Unterbrechung ausgebildet ist. Die Unterbrechung weist dabei kein Material mit demselben oder geringerem Mittelpunktsabstand zur Drehachse als die Innenfläche auf. Die Unterbrechungen können durch Rücksprünge und/oder durch Weglassen von Material gebildet sein.

Gemäß einer besonders bevorzugten Ausgestaltung dieser Variante erstreckt sich die Innenfläche durchgängig über einen Bereich von nicht mehr als einem halben Umlauf. Der Rest des Vollkreises wird dann durch eine einzige, zusammenhängende Unterbrechung gebildet. Zwar kann das Gleitlager in dieser Konfiguration keinen vollständig bestimmten Formschluss mit einer eindeutigen Drehbarkeit um die Drehachse gewährleisten, jedoch weist dieses Lager eine größere Toleranz gegenüber einer auf dem Lagerbolzen aufwachsenden Verschmutzung auf. Wenn etwa durch Eintrag eines Materials, insbesondere Beschichtungsmaterials der Lagerbolzen seinen Durchmesser vergrößert und/oder die Innenfläche ihren Innendurchmesser verkleinert, weist das Lager eine größere Toleranz zum Ausweichen auf.

Gemäß einer bevorzugten Variante ist entweder die erste Lagerfläche oder die zweite Lagerfläche unterbrochen ausgebildet. Dadurch wird insbesondere eine Kompatibilität mit bereits bestehenden Komponenten hergestellt. Diese können dann mit den erfindungsgemäßen Vorteilen weiter verwendet werden. Auch sinkt der konstruktive Aufwand, da bereits entwickelte Komponenten unverändert übernommen werden können.

Alternativ kann jedoch auch vorgesehen sein, dass sowohl die erste Lagerfläche als auch die zweite Lagerfläche unterbrochen sind. Durch die wechselseitige Unterbrechung kann die Abfuhr von etwaigen Fremdstoffen optimiert werden. Dabei muss jedoch geometrisch gewährleistet werden, dass stets ein flächiger Kontakt zwischen einzelnen Segmenten der beiden Lagerflächen und damit die beabsichtigte Lagerwirkung vorliegt - zumindest in dem vorgesehenen Bewegungsbereich zwischen der geschlossenen Position und der geöffneten Position. Dazu ist insbesondere vorgesehen, dass die unterbrechungsfreien Segmente der Lagerflächen jeweils (in vorgesehener Bewegungsrichtung des Gleitlagers) länger, insbesondere mindestens doppelt so lang, besonders bevorzugt zumindest dreimal so lang sind wie die Unterbrechungen der jeweils gegenüberliegenden Lagerfläche.

Gemäß einer bevorzugten Ausgestaltung weist die erste Fläche und/oder die zweite Lagerfläche zumindest eine Gruppe von parallel verlaufenden Unterbrechungen auf. Dadurch können die Unterbrechungen - und damit die abstützungsfreien Bereiche des Gleitlagers besser in der Kontaktfläche verteilt werden. Bevorzugt sind die Unterbrechungen einer Gruppe linear und untereinander parallel verlaufend ausgebildet, wobei der Verlauf zur vorgesehenen Bewegungsrichtung des Gleitlagers schräg, insbesondere quer ausgerichtet ist. Die Unterbrechungen einer Gruppe können beispielsweise bei einem rotatorischen Gleitlager achsparallel zu der Drehachse ausgerichtet sein.

Im Rahmen der Erfindung ist es auch denkbar, mehrere Gruppen von linear parallel verlaufenden Unterbrechungen vorzusehen. So können beispielsweise alternativ oder zusätzlich zu achsparallel verlaufenden Unterbrechungen eines zylindrischen Rotationslagers auch ein oder mehrere schraubenförmig umlaufende Unterbrechungen ausgebildet sein. Diese helikalen Unterbrechungen verteilen die abschabende Wirkung der zwischen den Segmenten und Unterbrechungen gebildeten Kanten besser am Umlauf eines rotativen Gleitlagers. Gleichzeitig wird auch der Abtransport gelöster Partikel verbessert.

Vorzugsweise ist das Halteelement passiv beweglich mit einem Rückstellelement ausgebildet. Dies bedeutet, dass das Halteelement durch Kraftbeaufschlagung in Richtung der geschlossenen Position vorgespannt ist. Ohne äußere Einwirkungen wird es sich daher in die geschlossene Position bewegen bzw. sich dieser annähern und so ein Werkstück in der Werkstückaufnahme sichern. Passiv bewegliche Halteelemente ermöglichen einen einfachen Aufbau. Gleichzeitig profitieren sie in besonderem Maße von der vorliegenden Erfindung, da deren Funktionieren von der Leichtgängigkeit des Gleitlagers abhängt.

Insbesondere ist das Rückstellelement mit einer Feder und/oder einem Gummielement ausgebildet. Bei dem Gummielement kann es sich insbesondere um einen Gummiring, insbesondere einen Dichtring handeln. Dichtringe haben neben ihrer großen Elastizität den Vorteil, dass diese für die Verwendung in anspruchsvollen Umgebungsbedingungen vorgesehen und zugelassen sind. Weiterhin sind diese in großer Anzahl und zu geringen Kosten verfügbar.

Besonders bevorzugt wird das Halteelement in einer Ruheposition, welche auch mit der geschlossenen Position des Halteelements identisch sein kann, an eine Anschlagfläche des Trägers gedrückt. Hierdurch wird eine definierte Endposition gewährleistet. Die Bewegung aus der Schließstellung ist ausschließlich durch Vermittlung des Gleitlagers und gegen die Kraft des Rückstellelements möglich.

Ein weiterer Aspekt der Erfindung betrifft eine Werkstückhalterung, insbesondere für eine Halte- und Dichtvorrichtung einer Plasmabeschichtungsanlage mit einem eine Werkstückaufnahme ausbildenden Träger und mit zumindest einem gegenüber dem Träger beweglichen Halteelement. Gemäß dem zweiten Aspekt der Erfindung weist das Halteelement einen an dem Träger starr befestigten Befestigungsabschnitt, einen zum Halten des Werkstücks eingerichteten Halteabschnitt und einen den Befestigungsabschnitt mit dem Halteabschnitt verbindenden und federelastisch ausgebildeten Verbindungsabschnitt auf. Die Beweglichkeit des Halteelements zwischen der geschlossenen und einer geöffneten Position wird dabei durch Verformung des Halteelements, insbesondere in dem Verbindungsabschnitt, gewährleistet. Dadurch kann ein Gleitlager auf eine einfache Kontaktfläche zwischen dem Halteelement und z. B. dem Träger begrenzt werden oder gänzlich entfallen. Es ist beispielsweise bevorzugt denkbar, dass zumindest der Halteabschnitt und gegebenenfalls auch zumindest Teile des Verbindungsabschnitts außerhalb der geschlossenen Position frei von der Werkstückhalterung vorstehen und keinen Kontakt zu dem Träger aufweisen.

Vorzugsweise ist vorgesehen, dass das Halteelement, insbesondere mit dem Verbindungsabschnitt, flächig an einer Anlagefläche des Trägers anliegt und an diesem geführt ist. Hierdurch wird ein Gleitlager in der Ebene der Anlagefläche gebildet. Dieses bietet zumindest eine begrenzte Stützwirkung, ist jedoch unempfindlich gegenüber Verschmutzungen der Anlagefläche. Sollten sich in dem Kontaktbereich zwischen dem Halteelement und der Anlagefläche Verschmutzungen ansammeln, so kann das Halteelement durch eine zusätzliche elastische Verformung normal zu der Fläche ausweichen.

Um eine ausreichende Beweglichkeit zu erzielen, weist der Verbindungsabschnitt eine Breite von nicht mehr als 10 mm, insbesondere nicht mehr als 7 mm auf. Die Breite meint dabei die Quererstreckung in der Ebene, in welcher das Halteelement durch Verformung bewegt werden kann. Die Breite kann in dem Verbindungsabschnitt konstant sein. Alternativ kann sich die Breite auch über den Verbindungsabschnitt verändern, um Spannungen im Material zu reduzieren. Dann ist insbesondere eine minimal Breite von nicht mehr als 10 mm, besonders bevorzugt nicht mehr als 7 mm vorgesehen.

Gemäß einer besonders bevorzugten Ausgestaltung sämtlicher vorbeschriebenen Ausführungsformen sind zwei gleichartige Halteelemente, insbesondere spiegelsymmetrisch ausgebildet. Diese können ein in der Werkstückaufnahme aufgenommenes Werkstück besonders vorteilhaft an zwei Seiten abstützen. Die Symmetrie ist insbesondere bezüglich einer Längsmittelebene gegeben, welche insbesondere durch eine Längserstreckungsachse des Werkstücks, insbesondere Behälters bzw. dessen Mündung verläuft.

Ein weiterer besonders bevorzugter Aspekt sieht vor, dass eine der zuvor beschriebene Werkstückhalterung ein erstes Teil und ein an dem ersten Teil an einer Kontaktfläche anliegendes und gegenüber diesem entlang der Kontaktfläche bewegliches zweites Teil aufweist. Bei dem ersten Teil und dem zweiten Teil kann es sich insbesondere um ein Halteelement, ein Lagerelement, z. B. einen Lagerbolzen oder den Träger handeln. Gemäß der bevorzugten Ausgestaltung ist das erste Teil zumindest im Bereich der Kontaktfläche aus einem hochmolekularen Polyethylen (PE), insbesondere mit einer mittleren Molmasse von zumindest 500.000 g/Mol gebildet und das zweite Teil zumindest im Bereich der Kontaktfläche aus Polyetheretherketon (PEEK) gebildet. Beide Materialien weisen gute Dielektrizitätseigenschaften auf und können daher vorteilhaft auch in Plasmabehandlungsstationen eingesetzt werden, welche mittels Mikrowellenenergie betrieben werden. Gleichzeitig weisen sie ähnliche mechanische Eigenschaften und ein gutes Gleitverhalten aneinander auf. Dadurch dass das Polyethylen weicher ist, konzentriert sich ein Verschleiß üblicherweise auf das mit PE gefertigte erste Teil.

Gemäß einer besonders bevorzugten Ausgestaltung handelt es sich bei dem Polyethylen um ein PE-HMW bzw. PE500 mit einer mittleren Molmasse zwischen 500.000 g/Mol und 1.000.000 g/Mol.

Besonders bevorzugt bilden das erste Teil und das zweite Teil ein Gleitlager aus, welches insbesondere in der zuvor beschrieben Form eine erste Lagerfläche und eine zweite Lagerfläche aufweist. Vorzugsweise kann dabei entweder die erste Lagerfläche von dem ersten Teil und die zweite Lagerfläche von dem zweiten Teil ausgebildet sein oder umgekehrt die erste Lagerfläche von dem zweiten Teil und die zweite Lagerfläche von dem ersten Teil ausgebildet sein.

Gegenstand der Erfindung ist auch eine Halte- und Dichtvorrichtung zum Halten und Abdichten eines Werkstücks, insbesondere Behälters mit einem eine Dichtung aufweisenden Dichtungsträger. Erfindungsgemäß ist eine Wwerkstückhalterung gemäß einer der zuvor beschriebenen Ausgestaltungen vorgesehen, welche in einer Hubbewegung zwischen einer Grundstellung und einer Dichtstellung relativ zu dem Dichtungsträger beweglich geführt ist. Die Halte- und Dichtvorrichtung ist dazu eingerichtet, an der Werkstückhalterung ein Werkstück, insbesondere einen Behälter, aufzunehmen und dieses durch die Hubbewegung in Richtung der Dichtposition dichtend mit der Dichtung in Anlage zu bringen. Dadurch ist zum Beispiel bei einem Behandlungsprozess - beispielsweise bei einer Plasmabeschichtung die Möglichkeit gegeben, den von einem Behälter umschlossenen Innenraum und den ihn umgebenden Außenraum separat anzusteuern. Infolgedessen können die Innenseite und die Außenseite des Behälters voneinander unabhängig behandelt werden.

Weiterhin betrifft die Erfindung auch eine Plasmabehandlungsanlage mit zumindest einer Plasmabehandlungsstation. Erfindungsgemäß ist zumindest eine Werkstückhalterung vorgesehen, wie diese in einem der vorangegangenen Beispiele beschrieben ist. Insbesondere ist die Werkstückhalterung Teil einer insbesondere erfindungsgemäßen Halte- und Dichtvorrichtung wie zuvor dargestellt. Die Werkstückhalterung ist zumindest teilweise innerhalb der Plasmabehandlungsstation angeordnet.

Die Erfindung wird nachfolgend anhand von den lediglich Ausführungsbeispiele darstellenden Figuren erläutert. Diese zeigen dabei schematisch:
- Fig. 1: eine schematische Darstellung einer erfindungsgemäßen Plasmabehandlungsanlage,
- Fig. 2: eine perspektivische Darstellung einer erfindungsgemäßen Halte- und Dichtvorrichtung,
- Fig. 3A: eine perspektivische Darstellung der in Fig. 2 dargestellten erfindungsgemäßen Werkstückhalterung,
- Fig. 3B: eine Detailansicht des Lagerbolzens aus Fig. 3A,
- Fig. 4A: eine perspektivische Darstellung einer erfindungsgemäßen Werkstückhalterung gemäß einer alternativen Ausführungsform,
- Fig. 4B: eine detaillierte Darstellung des Halteelements aus Fig. 4A,
- Fig. 5A: eine perspektivische Darstellung einer weiteren Ausführungsform einer erfindungsgemäßen Werkstückhalterung und
- Fig. 5B: eine detaillierte Darstellung des Halteelements aus Fig. 5A.

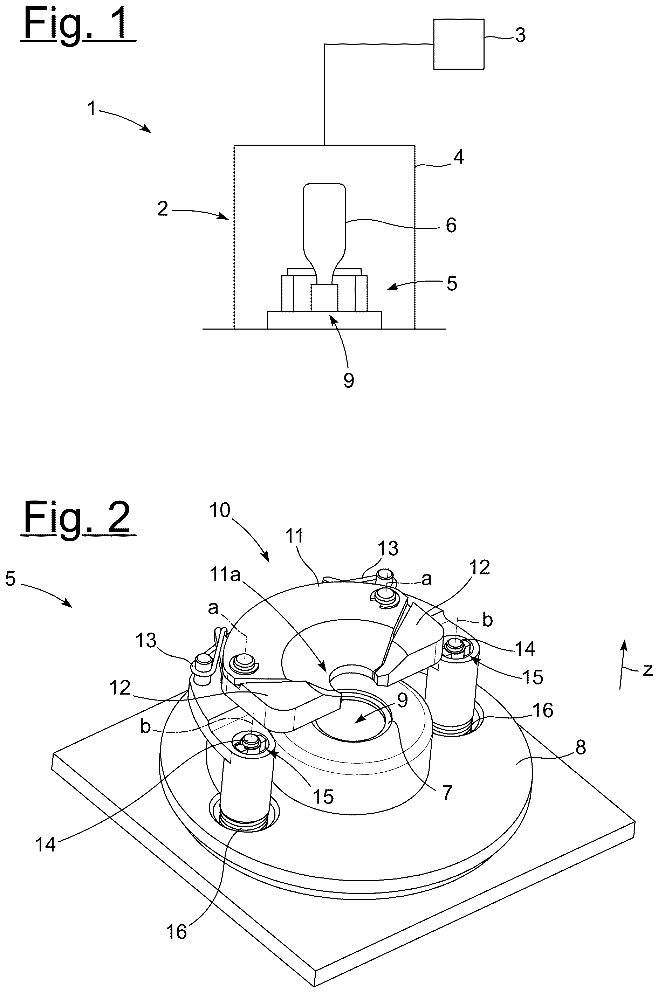

Die Fig. 1 zeigt eine erfindungsgemäße Plasmabehandlungsanlage 1 mit einer Plasmabehandlungsstation 2 und einer an die Plasmabehandlungsstation 2 angeschlossenen Mikrowellenquelle 3. Die Plasmabehandlungsstation 2 weist eine an die Mikrowellenquelle 3 angeschlossene Kavität 4 auf, welche in Fig. 1 schematisch in einer geschlossenen Position dargestellt ist. In die geschlossene Kavität 4 hinein erstreckt sich eine erfindungsgemäße Halte- und Dichtvorrichtung 5, an der ein Werkstück 6 in Gestalt eines Behälters aufgenommen ist.

Die Halte- und Dichtvorrichtung 5 zum Halten und Abdichten des Werkstücks 6 in der Plasmabehandlungsstation 2 ist in größerem Detail in Fig. 2 dargestellt: Diese umfasst einen eine Dichtung 7 aufweisenden Dichtungsträger 8. In dem dargestellten Ausführungsbeispiel wird der Dichtungsträger 8 durch eine ortsfest an der Plasmabehandlungsstation 2 angeordnete Grundplatte gebildet. Zentral innerhalb der Dichtung 7 ist eine Öffnung 9 ausgebildet, durch die insbesondere Prozessgase in das Innere des Werkstücks 6 eingeleitet werden können.

Die Halte- und Dichtvorrichtung 5 umfasst ferner eine Werkstückhalterung 10 zum Halten des Werkstücks 6, welche in einer Hubbewegung zwischen einer Grundposition und einer Dichtposition gegenüber dem Dichtungsträger 8 verlagert werden kann. Fig. 2 zeigt dabei die Grundposition zur besseren Sichtbarkeit ohne das Werkstück 6. In der Grundposition weisen der Dichtungsträger 8 und die auch als Behälterhalterung bezeichnete Werkstückhalterung 10 zueinander einen größeren Abstand auf als in der Dichtposition, bei der ein an der Werkstückhalterung 10 aufgenommenes Werkstück 6 an der Dichtung 7 dichtend anliegt

Zur Aufnahme des Werkstücks 6 weist die Werkstückhalterung 10 einen eine Werkstückaufnahme 11a ausbildenden Träger 11 sowie zwei gegenüber dem Träger 11 bewegliche Halteelemente 12 auf. In dem dargestellten Ausführungsbeispiel sind die beiden Halteelemente als Haltefinger ausgebildet, welche um vertikal verlaufende Drehachsen a drehbar gehalten sind. Durch rückwärtig an die Halteelemente 12 angreifende elastische Rückstellelemente 13 wird eine Schwenkbewegung in Richtung der Werkstückaufnahme 11a bewirkt, sodass ein in die Werkstückaufnahme 11a eingelegtes Werkstück 6 durch Kraftbeaufschlagung der Halteelemente 12 gehalten wird.

Die Werkstückhalterung 10 - und gegebenenfalls ein daran gehaltenes Werkstück 6 - sind in einer Hubbewegung gegenüber dem Dichtungsträger 8 verlagerbar. Dazu ist vorgesehen, dass während eines Plasma-(Beschichtungs-)Prozesses das Werkstück 6 zunächst in die Werkstückhalterung 10 eingesetzt wird, während diese die in der Figur dargestellte Grundposition einnimmt. In dieser verbleibt zwischen der Mündung des Werkstücks 6 und der Dichtung 7 in der Vertikalrichtung z ein Abstand, während die Mündung bereits mit der Öffnung 9 innerhalb der Dichtung 7 fluchtet.

Anschließend wird die Werkstückhalterung 10 mit dem daran aufgenommenen Werkstück 6 auf den Dichtungsträger 8 zu bewegt, sodass die Mündung des Werkstücks 6 mit der Dichtung 7 in Kontakt tritt und damit zwei Volumina innerhalb und außerhalb des Werkstücks 6 (Behälters) voneinander abteilt. Durch Evakuieren des Innenraums der Kavität 4 werden Bedingungen hergestellt, unter denen ein Plasma zünden kann, wobei der Druck innerhalb und außerhalb des Werkstücks 6 aneinander angeglichen wird, um eine ungewollte Verformung des Werkstücks 6 zu verhindern.

Zumindest eins der beiden Volumina innerhalb oder außerhalb des Werkstücks 6 wird anschließend mit einem Prozessgas bzw. Gasgemisch gespült, aus dem durch Mikrowellen-induziertes Zünden eines Plasmas innerhalb der Kavität 4 Beschichtungsmoleküle abgespalten werden, die sich an der Oberfläche des Werkstücks 6 anlagern.

Die unterschiedliche Stoffzusammensetzung des bzw. der Prozessgase und unterschiedliche Charakteristiken beim Eintrag der Mikrowellenenergie können dabei Schichten unterschiedlicher Abmessung und Zusammensetzung erzeugen. Diese können insbesondere in einem mehrstufigen Prozess zu mehrlagigen Beschichtungen kombiniert werden. Beispielsweise wird zunächst eine Haftvermittlerschicht auf das Substrat des Werkstücks - in der Regel ein Kunststoff, insbesondere Polyethylenterephthalat (PET) - aufgebracht. Die Haftvermittlerschicht wird anschließend mit einer die hauptsächliche Barrierewirkung vermittelnden Barriereschicht überzogen und anschließend durch eine obere Schutzschicht - das sogenannte Topcoating - abgeschlossen und versiegelt.

Zum Entnehmen des behandelten, insbesondere beschichteten Werkstücks 6 werden die Werkstückhalterung 10 und der Dichtungsträger 8 in einer Hubbewegung voneinander entfernt, sodass das Werkstück 6 den Kontakt zu der Dichtung 7 verliert und mit geringem mechanischen Aufwand aus der Werkstückhalterung 10 entnommen werden kann.

Die Hubbewegung ist mittels zweier Führungsbolzen 14 geführt, welche an dem Dichtungsträger 8 angeordnet sind und zugeordnete Aufnahmen 15 der Werkstückhalterung 10 durchgreifen. In dem dargestellten Ausführungsbeispiel sind die Führungsbolzen 14 in der Vertikalrichtung z ausgerichtet und ermöglichen so eine lineare Führung der Werkstückhalterung 10 an dem Dichtungsträger 8. Die Hubbewegung ist dabei durch zwei Schraubenfedern 16 in der Vertikalrichtung nach oben vorgespannt. Eine Verlagerung aus der dargestellten Grundposition in die Dichtposition erfolgt gegen die Rückstellkraft der Schraubenfedern 16.

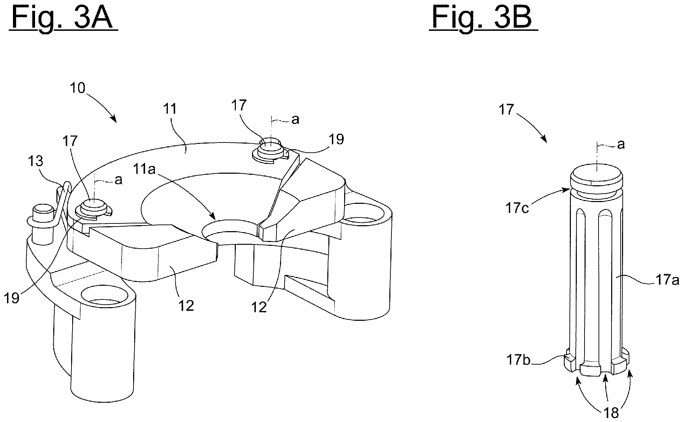

Eine erste erfindungsgemäße Ausführungsvariante des Gleitlagers zwischen dem Halteelement 12 und dem Träger 11 ist in den Figuren 3A und 3B dargestellt: Dieses weist einen Lagerbolzen 17 auf, welcher eine um die Drehachse a zylindersymmetrisch verlaufende erste Lagerfläche 17a bildet. Diese ist im zusammengesetzten Zustand gemäß der Fig. 3A entlang einer Kontaktfläche in Anlage mit einer von dem Halteelement 12 ausgebildeten korrespondierenden zweiten Lagerfläche. Erfindungsgemäß ist in dieser Ausführungsform die erste Lagerfläche 17a durch parallel zu der Drehachse a verlaufende schlitzförmige Vertiefungen 18 unterbrochen.

Die schlitzförmigen Vertiefungen 18 erstrecken sich dabei in der Längserstreckungsrichtung des Lagerbolzens 17, d.h. in axialer Richtung nach unten bis durch die unterseitigen Vorsprünge 17b, welche als Anschlagselement an der Unterseite des Trägers 11 dienen. Dadurch ist es möglich, dass an den Kanten zwischen den Lagerflächensegmenten 17a und den dazwischen liegenden Vertiefungen 18 gebildeten Kanten gelöste Verunreinigungs-Partikel infolge der Schwerkraftwirkung und/oder von Vibrationen des im Betrieb einer wiederholten Hubbewegung unterzogenen Trägers 11 gelöst werden und unterseitig aus dem System ausgeschleust werden können. Im oberen Bereich des Lagerbolzens 17 ist ferner eine Sicherungsnut 17c ausgebildet, in die ein Sicherungselement 19 eingesetzt werden kann.

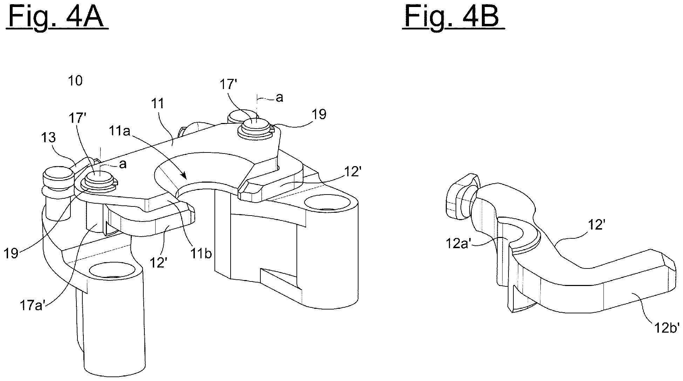

Eine alternative Ausgestaltung der Erfindung ist in den Figuren 4A und 4B dargestellt. Dabei ist an dem Träger 11 eine alternative Fassung eines Lagerbolzens 17' mit einer durchgängig zylindrischen ersten Lagerfläche 17a' angeordnet. Gemäß der Detaildarstellung in Fig. 4B ist erkennbar, dass das zugeordnete alternative Halteelement 12' eine zweite, innere Lagerfläche 12a' aufweist. Diese ist unterbrochen und erstreckt sich um weniger als 180° entlang des Umfangs. Der sich in die Werkstückaufnahme 11a hinein erstreckende Haltefinger 12b' liegt dabei in der geschlossenen Position formschlüssig an einer Anschlagfläche 11b des Trägers 11 an. Dadurch wird eine eindeutige Lage des Halteelements 12' bei der Kraftbeaufschlagung durch das elastische Element 13 gewährleistet.

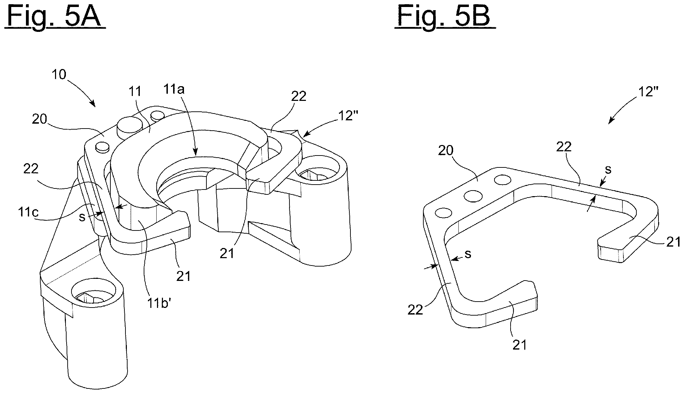

Eine dritte erfindungsgemäße Ausführungsform ist in den Figuren 5A und 5B dargestellt. Das dort vorgesehene Halteelement 12" ist dadurch gekennzeichnet, dass es einen an dem Träger 11 starr befestigten Befestigungsabschnitt 20 sowie zwei Halteabschnitte 21 aufweist, welche sich in die Öffnung der Werkstückaufnahme 11a hinein erstrecken. Die Halteabschnitte 21 sind mit dem Befestigungsabschnitt 20 durch zwei federelastisch ausgebildete Verbindungsabschnitte 22 verbunden. Die Verbindungsabschnitte 22 weisen - in der horizontalen Bewegungsebene - eine Breite s von nicht mehr als 10 mm auf. Dieses Halteelement 12" umfasst in einem Teil zwei symmetrische Halteabschnitte 21, welche die Werkstückaufnahme 11a beidseitig umschließen. In der in Fig. 5A dargestellten geschlossenen Position liegen die beiden Halteabschnitte 21 formschlüssig an einem Anlageabschnitt 11b' des Trägers 11 an. Ferner sind die Verbindungsabschnitte 22 an einer horizontal verlaufenden Anlagefläche 11c des Trägers 11 geführt.

### Bezugszeichenliste:

- 1: Plasmabehandlungsanlage
- 2: Plasmabehandlungstation
- 3: Mikrowellenquelle
- 4: Kavität
- 5: Halte- und Dichtvorrichtung
- 6: Werkstück, insbes. Behälter
- 7: Dichtung
- 8: Dichtungsträger
- 9: Öffnung
- 10: Werkstückhalterung
- 11: Träger
- 11a: Werkstückaufnahme
- 11b: Anschlagfläche, Anlageabschnitt
- 11c: Anlagefläche
- 12, 12', 12": Halteelement
- 12a': innere Lagerfläche
- 12b': Haltefinger
- 13: elastisches Rückstellelement
- 14: Führungsbolzen
- 14a: Nut
- 14b: äußere Anlagefläche
- 14c: Schulter
- 15: Aufnahme
- 15a: innere Anlagefläche
- 15b: Durchbruch
- 16: Federelement, Schraubenfeder
- 17: Lagerbolzen
- 17': Lagerbolzen
- 17a, 17a': erste Lagerfläche,
- 17b: unterseitige Vorsprünge
- 17c: Sicherungsnut
- 18: schlitzförmige Vertiefung
- 19: Sicherungselement
- 20: Befestigungsabschnitt
- 21: Halteabschnitt
- 22: Verbindungsabschnitt
- a: Drehachse
- s: Breite
- z: Vertikalrichtung

## Patentansprüche

1. Werkstückhalterung (10), insbesondere für eine Halte- und Dichtvorrichtung (5) einer Plasmabehandlungsanlage (1), mit einem eine Werkstückaufnahme (11a) ausbildenden Träger (11) und mit einem Halteelement (12, 12', 12"), welches über ein Gleitlager beweglich an dem Träger (11) geführt ist, wobei das Gleitlager eine erste Lagerfläche (17a, 17a') aufweist, an der eine zweite Lagerfläche (12a') flächig anliegt, **dadurch gekennzeichnet, dass** die erste Lagerfläche (17a, 17a') und/oder die zweite Lagerfläche (12a') unterbrochen ausgebildet sind.

2. Werkstückhalterung (10) nach dem vorangegangenen Anspruch, **gekennzeichnet durch** einen Lagerbolzen mit einer um eine Drehachse (a) rotationssymmetrischen Außenfläche, welche die erste Lagerfläche (17a, 17a') bildet, und **dadurch, dass** der Träger (11) oder das Halteelement (12) eine um die Drehsachse (a) rotationssymmetrische Innenfläche aufweist, welche die zweite Lagerfläche (12a') bildet.

3. Werkstückhalterung (10) nach dem vorangegangenen Anspruch, **dadurch gekennzeichnet, dass** der Lagerbolzen (14) eine zylindrische Außenform (17a) aufweist, welche durch längs der Drehachse (a) verlaufende schlitzförmige Vertiefungen (18) unterbrochen ist.

4. Werkstückhalterung (10) nach einem der vorangegangenen Ansprüche 2 oder 3, **dadurch gekennzeichnet, dass** die Innenfläche (12a') zylindersymmetrisch um die Drehachse (a) mit zumindest einer Unterbrechung ausgebildet ist.

5. Werkstückhalterung (10) nach dem vorangegangenen Anspruch, **dadurch gekennzeichnet, dass** sich die Innenfläche (12a') durchgängig über einen Bereich von nicht mehr als einem halben Umlauf erstreckt.

6. Werkstückaufnahme (11a) nach einem der vorangegangenen Ansprüche, **dadurch gekennzeichnet, dass** entweder die erste Lagerfläche (17a) oder die zweite Lagerfläche (12a') unterbrochen ausgebildet ist.

7. Werkstückhalterung (10) nach einem der vorangegangenen Ansprüche, **dadurch gekennzeichnet, dass** das Halteelement (12, 12', 12") passiv beweglich mit einem, insbesondere eine Feder und/oder ein Gummielement umfassenden Rückstellelement (13) ausgebildet ist.

8. Werkstückhalterung (10) nach einem der vorangegangenen Ansprüche, **dadurch gekennzeichnet, dass** das Halteelement (12, 12') in einer geschlossenen Position an eine Anschlagfläche der Aufnahme gedrückt wird.

9. Werkstückhalterung (10), insbesondere für eine Halte- und Dichtvorrichtung (5) einer Plasmabehandlungsanlage (1), mit einem eine Werkstückaufnahme (11a) ausbildenden Träger (11) und mit zumindest einem gegenüber dem Träger (11) beweglichen Halteelement (12"), **dadurch gekennzeichnet, dass** das Halteelement (12") mit einem an dem Träger (11) befestigten Befestigungsabschnitt (20), mit einem zum Halten des Werkstücks (6) eingerichteten Halteabschnitt (21) und mit einem den Befestigungsabschnitt (20) mit dem Halteabschnitt (21) verbindenden und federelastischen Verbindungsabschnitt (22) ausgebildet ist.

10. Werkstückhalterung (10) nach dem vorangegangenen Anspruch, **dadurch gekennzeichnet, dass** das Halteelement (12"), insbesondere mit dem Verbindungsabschnitt (22), flächig an einer Außenfläche des Trägers (11) anliegt und an dieser geführt ist.

11. Werkstückhalterung (10) nach einem der vorangegangenen Ansprüche 9 oder 10, **dadurch gekennzeichnet, dass** der Verbindungsabschnitt (22) eine Breite von nicht mehr als 10 mm, insbesondere von nicht mehr als 7 mm aufweist.

12. Werkstückhalterung (10) nach einem der vorangegangenen Ansprüche, **dadurch gekennzeichnet, dass** zwei gleichartige Halteelemente (12, 12', 12"), insbesondere symmetrisch ausgebildet sind.

13. Werkstückhalterung (10) nach einem der vorangegangenen Ansprüche, **dadurch gekennzeichnet, dass** diese ein erstes Teil und ein an dem ersten Teil anliegendes und gegenüber diesem entlang einer Kontaktfläche geführtes zweites Teil aufweist und dass das erste Teil zumindest im Bereich der Kontaktfläche aus einem hochmolekularen Polyethylen, insbesondere PE 500, gebildet ist und dass das zweite Teil zumindest im Bereich der Kontaktfläche aus Polyetheretherketon (PEEK) gebildet ist.

14. Halte- und Dichtvorrichtung (5) zum Halten und Abdichten eines Werkstücks mit einem eine Dichtung aufweisenden Dichtungsträger (11), **gekennzeichnet durch** eine Werkstückhalterung (10) nach einem der vorangegangenen Ansprüche, welche relativ zu dem Dichtungsträger (11) in einer Hubrichtung bewegbar geführt ist.

15. Plasmabehandlungsanlage mit zumindest einer Plasmabehandlungsstation, **gekennzeichnet durch** zumindest eine Werkstückhalterung (10) nach einem der vorangegangenen Ansprüche, insbesondere im Rahmen einer Halte- und Dichtvorrichtung (5) nach dem vorangegangenen Anspruch, welche zumindest teilweise innerhalb der Plasmabehandlungsstation angeordnet ist.
